**Europäisches Patentamt**

**European Patent Office**

**Office européen des brevets**

(19)

(11) Veröffentlichungsnummer: **0 119 628**
**B1**

(12) **EUROPÄISCHE PATENTSCHRIFT**

(45) Veröffentlichungstag der Patentschrift:
**15.11.89**

(21) Anmeldenummer: **84103020.8**

(22) Anmeldetag: **19.03.84**

(51) Int. Cl.⁴: **H 03 J 5/24,** H 04 B 1/04,
H 03 H 7/46

(54) **Breitbandiger Sender für kurze elektromagnetische Wellen.**

(30) Priorität: **22.03.83 DE 3310389**

(43) Veröffentlichungstag der Anmeldung:
**26.09.84 Patentblatt 84/39**

(45) Bekanntmachung des Hinweises auf die Patenterteilung:
**15.11.89 Patentblatt 89/46**

(84) Benannte Vertragsstaaten:
**AT BE CH DE FR GB IT LI NL SE**

(56) Entgegenhaltungen:
**US-A-1 485 111**
**US-A-4 165 493**

**ELECTRONIC COMPONENTS AND APPLICATIONS,**
**Band 3, Nr. 4, August 1981, Seiten 210-223,**
**Eindhoven, NL; J. LING: "Wideband linear**
**amplifiers in h.f. communications"**

(73) Patentinhaber: **Siemens Aktiengesellschaft,**
**Wittelsbacherplatz 2, D-8000 München 2 (DE)**

(72) Erfinder: **Zirwas, Johann Gerhard, Dr.- Ing.,**
**Mittenwalder Strasse 136, D-8038 Gröbenzell (DE)**

## Beschreibung

Die Erfindung bezieht sich auf einen, in einem breiten Frequenzband durchstimmbaren Sender, insbesondere Kurzwellensender, mit einem im Gegentakt arbeitenden Endverstärker, vorzugsweise Transistorverstärker und einer zwischen dem Endverstärkerausgang und dem Senderausgang vorgesehenen Filteranordnung, deren Teilfilter, die bestimmten Teilfrequenzbereichen der Senderarbeitsfrequenz zugeordnet sind und der Unterdrückung unerwünschter Oberwellen der Senderarbeitsfrequenzen dienen, alternativ in Abhängigkeit der Senderarbeitsfrequenz ein- und ausgangsseitig über elektrisch steuerbare Schalter in den Signalweg einschaltbar sind.

Derartige Sendereinrichtungen sind beispielsweise in der Literaturstelle "Electronic Components and Applications", Vol. 3, No. 4, August 1981, Seiten 210 bis 223 bekannt. Im Kurzwellenbereich zwischen 1,5 und 30 MHz haben sich dabei bis zu Leistungen von 1 kW breitbandige Transistorverstärker als Senderendverstärker weitgehend durchgesetzt. Da derartige Transistorverstärker die üblichen Anforderungen an die Linearität nicht voll erfüllen können, müssen verstärkerausgangsseitig Maßnahmen vorgesehen werden, um unerwünschte Oberwellen zu unterdrücken. Besonders kritisch ist dabei die zweite Oberwelle der Grundschwingung, die durch die im Transistorverstärker in der Regel vorgesehene Gegentaktschaltung nicht ausreichend genug unterdrückt wird. Die erwähnte Filteranordnung zwischen dem Ausgang des Endverstärkers und dem Ausgang des Senders für die Oberwellenunterdrückung ist außerordentlich teuer und aufwendig, da sie für die volle Sendeleistung ausgelegt werden muß. Die Filteranordnung besteht dabei aus einer Anzahl von Suboktavfiltern, die aus Anpassungsgründen alternativ in den Signalweg in Abhängigkeit der Senderarbeitsfrequenz eingefügt werden müssen. Für den Kurzwellenbereich von 1,5 bis 30 MHz beispielsweise, sind mindestens acht Teilfilter erforderlich, die aus Impedanzgründen jeweils am Eingang und am Ausgang mit einem eigenen Relais umgeschaltet werden müssen.

Der Erfindung liegt die Aufgabe zugrunde, für eine bei einem solchen Sender erforderliche Filteranordnung eine weitere Lösung anzugeben, die bei vorgegebenem Gesamtfrequenzbereich für die Senderarbeitsfrequenz und den hierbei zu fordernden Sperrdämpfungen für die Oberwellen, bezogen auf bekannte Filteranordnungen, mit einem wesentlich geringeren fertigungstechnischen Aufwand auskommt.

Diese Aufgabe wird, ausgehend von einem Sender der einleitend beschriebenen Art gemäß der Erfindung durch die im Kennzeichen des Patentanspruches 1 angegebenen Merkmale gelöst.

Der Erfindung liegt die Erkenntnis zugrunde, daß die Anforderungen an die Sperrdämpfung eines Teilfilters nicht auf die für die zweite Oberwelle zu fordernde Dämpfung abgestellt sein muß, weil für die Dämpfung der zweiten Oberwelle auch das im Frequenzbereich nächstfolgende Teilfilter zusätzlich mit herangezogen werden kann. Da die erste Oberwelle der Senderarbeitsfrequenz durch die Gegentaktschaltung der Senderendstufe bereits sehr klein ist, genügt für diese Oberwelle bereits eine Dämpfung in der Größenordnung von 20 dB. Dies ermöglicht gegenüber einem Teilfilter, das die zweite Oberwelle bereits mit wenigstens 40 dB dämpfen soll, eine Einsparung von Spulen und Kondensatoren.

Wegen der geringeren Sperranforderung für ein Teilfilter läßt sich auch unter sonst gleichen Bedingungen der Sperrbereich jedes Teilfilters dichter an den jeweiligen Durchlaßbereich heranschieben. Die Unterteilung des Gesamtfrequenzbereiches der Senderarbeitsfrequenz kann dadurch in größere Teilfrequenzbereiche unterteilt werden, wodurch gegebenenfalls gegenüber bisherigen Sendern die Einsparung eines Teilfrequenzbereiches und damit eines Teilfilters erreicht wird.

Da die Übersprechdämpfung der Schalter, die die Teilfilter in den Signalweg einschalten, nur groß gegen die Filterdämpfung im Sperrbereich sein muß und hier die Sperrdämpfung eines Teilfilters relativ niedrig ist, ist es in außerordentlich vorteilhafter Weise möglich, die ein- und ausgangsseitigen Umschaltkontakte für ein solches Teilfilter einem einzigen Relais zuzuordnen, wodurch pro Filterbereich ein Relais eingespart werden kann.

Vorteilhafte Ausgestaltungen der Erfindung sind in den Patentansprüche 2 bis 6 angegeben.

Anhand von in der Zeichnung dargestellten Ausführungsbeispielen soll die Erfindung im folgenden noch näher erläutert werden. In der Zeichnung bedeuten

Fig. 1    eine bekannte Filteranordnung für den Kurzwellenbereich zwischen 1,5 und 30 MHz,

Fig. 2    ein bekanntes Teilfilter in Form eines Suboktav-Tiefpaßfilters,

Fig. 3    ein bekanntes Teilfilter in Form einer Tiefpaß-Hochpaßweiche,

Fig. 4    ein der Fig. 2 entsprechendes Teilfilter nach der Erfindung,

Fig. 5    eine erste Ausführungsform einer Filteranordnung nach der Erfindung,

Fig. 6    eine zweite Ausführungsform einer Filteranordnung nach der Erfindung,

Fig. 7    eine das Schaltschema der Filteranordnung nach den Fig. 5 und 6 für die einzelnen Teilfrequenzbereiche erläuternde Tabelle und

Fig. 8    eine dritte Ausführungsform einer Filteranordnung nach der Erfindung.

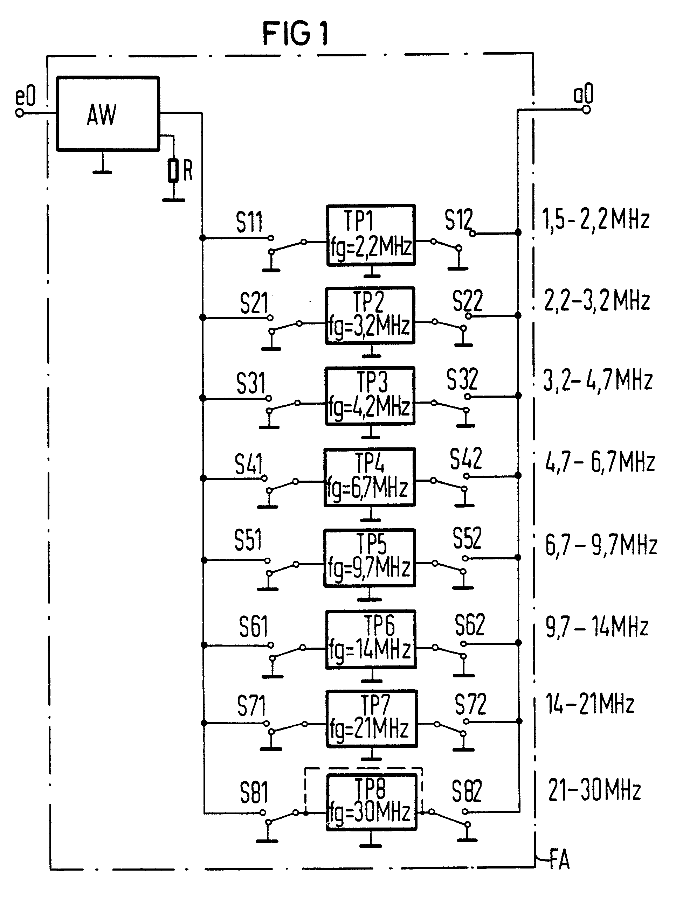

Um die Ersparnis des Aufwands durch das erfindungsgemäße Filterkonzept bei einem Sender zu verdeutlichen, ist zunächst in Fig. 1 eine bekannte Filteranordnung FA für einen Kurzwellensender im Frequenzbereich 1,5 bis 30 MHz angegeben. Die weiteren Figuren, einschließlich der erfindungsgemäßen Ausführungsbeispiele sind auf eine solche Filteranordnung für einen Kurzwellensender abgestellt. Es ist jedoch festzustellen, daß die Erfindung darauf nicht beschränkt ist, sondern in gleicher Weise auch für Senderanordnungen, die in einem niedrigeren oder in einem höheren Frequenzbereich arbeiten, in gleicher Weise Bedeutung hat.

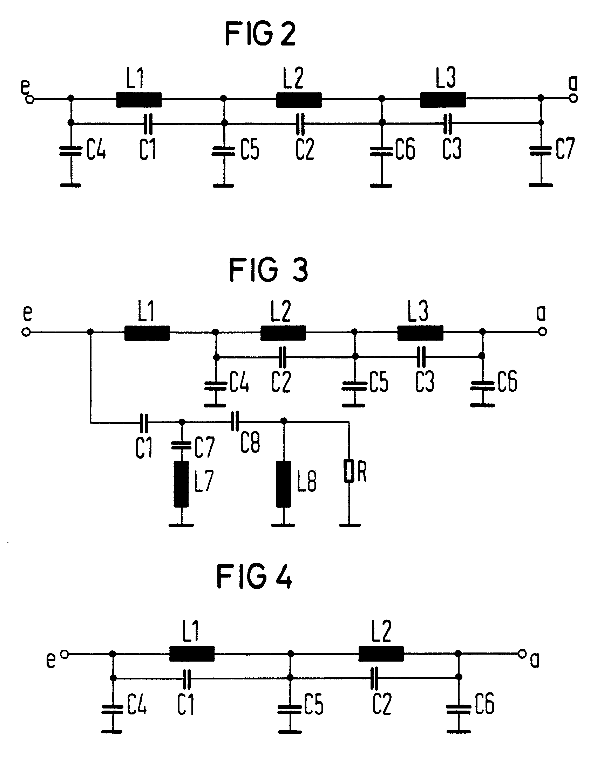

Die bekannte Filteranordnung FA nach Fig. 1 weist acht Teilfilter TP1, TP2...TP8 auf. Sie sind als Kauerparametertiefpässe mit drei Polen ausgeführt, und bestehen jeweils, wie das Tiefpaßfilter in Fig. 2 zeigt, zwischen Eingang e und Ausgang a aus drei Induktivitäten L1, L2 und L3 und sieben Kondensatoren C1...C7. Die Grenzfrequenzen fg dieser Teilfilter, wie auch die Teilfrequenzbereiche, denen die Teilfilter zugeordnet sind, sind in Fig. 1 ebenfalls angegeben. Anstelle des für den höchsten Teilfrequenzbereich von 21 bis 30 MHz ausgelegten Teilfilters TP8 kann ein Außerbandfilter AW vorgesehen sein, das aus einer Tiefpaß-Hochpaßkombination besteht und in Fig. 3 ebenfalls dargestellt ist. Es besteht, wie Fig. 3 zeigt, aus fünf Induktivitäten L1, L2, L3, L7 und L8 und acht Kondensatoren C1...C8. Der Hochpaßausgang ist dabei mit einem Lastwiderstand R abgeschlossen. Das Außerbandfilter AW ist ständig in den Signalweg eingeschaltet. Der Lastwiderstand R am Ausgang des Hochpasses bewirkt, daß die Oberwellen im Frequenzbereich ab 14 MHz, nicht zur Senderendstufe hin zurückreflektiert werden, sondern im Lastwiderstand R in Verlustleistung umgesetzt werden. Auf diese Weise wird verhindert, daß die in die Endstufe zurückreflektierten Oberwellen gerade im oberen Frequenzbereich das eigentliche Nutzsignal je nach Phasenlage ungünstig beeinflussen.

Wie Fig. 1 weiterhin zeigt, werden die Teilfilter TP1...TP8 ein- und ausgangsseitig durch elektrisch gesteuerte Schalter S11, S21,...S81 bzw. S12, S22,...S82 alternativ in Abhängigkeit der Senderarbeitsfrequenz fo in den Signalweg zwischen dem Eingang eO und dem Ausgang aO der Filteranordnung FA eingeschaltet. Wie bereits schon erwähnt wurde, erfordert hier die Übersprechdämpfung wegen der relativ hohen Sperrdämpfung der Teilfilter für die zweite Oberwelle in der Größenordnung von 40 dB, daß die ein- und ausgangsseitigen Schalter, beispielsweise beim Teilfilter TP1 die Schalter S11 und S12 jeweils durch ein Relais realisiert werden müssen. Auch in dem Falle, in dem anstelle des Teilfilters TP8 von dem in Fig. 1 dargestellten Außerbandfilter AW Gebrauch gemacht wird, werden die Schalter S81 und S82 ebenfalls benötigt, und zwar für die Durchschaltung des dem höchsten Teilfrequenzbereich zugeordneten Außerbandfilters AW bei entsprechend hoher Senderarbeitsfrequenz fo zum Ausgang aO.

Wie bereits darauf hingewiesen worden ist, wird bei der Erfindung von der wesentlichen Erkenntnis ausgegangen, daß die hohe Sperrdämpfung von 40 dB lediglich für den Bereich der zweiten Oberwelle benötigt wird, während für eine ausreichende Dämpfung der ersten Oberwelle, die durch die Gegentaktschaltung der Endverstärkerstufe bereits stark gedämpft ist, lediglich eine Sperrdämpfung von etwa 20 dB benötigt wird. Es ist also möglich, die Teilfilter lediglich für eine Sperrdämpfung von ca. 20 dB auszulegen, und die erforderlichen 40 dB für die zweite Oberwelle und gegebenenfalls auch für weitere Oberwellen höherer Ordnung durch die Hintereinanderschaltung von zwei oder auch mehr Teilfiltern im Signalweg sicherzustellen. Wie Fig. 4 zeigt, genügt es im Unterschied zum Tiefpaßfilter mit drei Polen nach Fig. 2, in diesem Falle die Teilfilter als Tiefpaßfilter lediglich mit zwei Polen auszuführen. Auf diese Weise lassen sich eine Induktivität und zwei Kondensatoren einsparen.

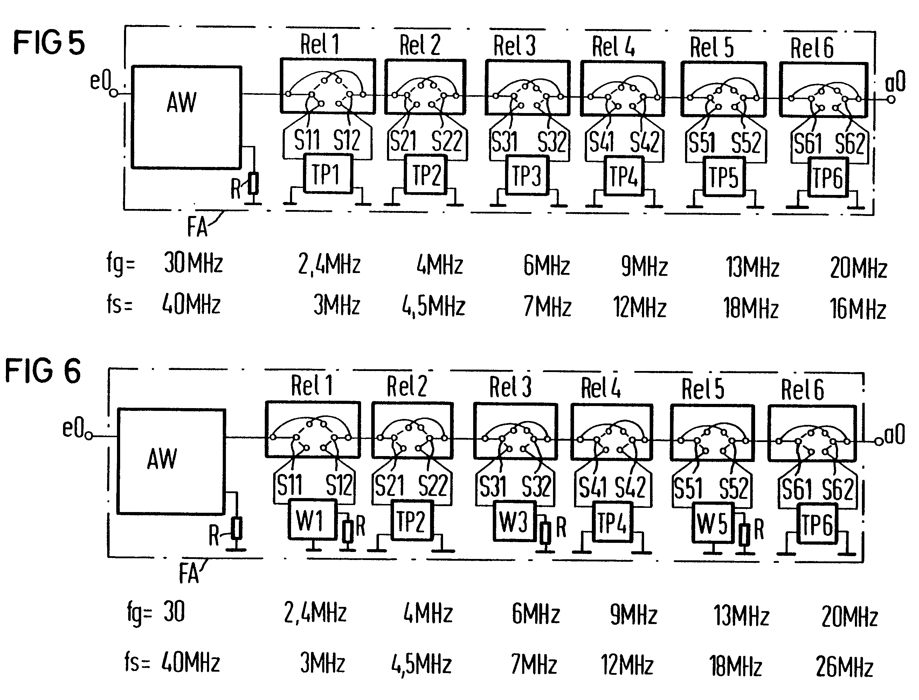

Das in Fig. 5 dargestellte erste Ausführungsbeispiel für eine Filteranordnung FA nach der Erfindung, macht ebenfalls von der Außerbandweiche AW Gebrauch, die hierbei das dem höchsten Teilfrequenzbereich der Senderarbeitsfrequenz fo zugeordnete Teilfrequenzfilter ist. An den Ausgang der Außerbandweiche AW schließen sich über Relais Rel1...Rel6 in den Signalweg einschaltbare Teilfilter TP1....TP6 an. Entsprechend der Fig. 1 ist das Ausführungsbeispiel der Fig. 5 für eine Filteranordnung in einem Kurzwellensender für den Frequenzbereich von 1,5 bis 30 MHz ausgelegt. Die Grenzfrequenzen fg, bei denen die Teilfilter noch praktisch keine Dämpfung aufweisen, und die Sperrfrequenzen fs, bei denen die Teilfilter die gewünschte Sperrdämpfung oberhalb des Durchlaßbereiches erreichen, sind unterhalb der Teilfilter angegeben. Im Unterschied zur bekannten Filteranordnung FA nach Fig. 1 kommt die Filteranordnung FA nach Fig. 5 mit einem Teilfilter weniger aus. Auch die Zahl der Relais hat sich von 16 auf 6 vermindert, da hier jedem Relais für Ein- und Ausgang eines Teilfilters jeweils zwei Umschaltkontakte ein und desselben Relais zugeordnet werden können.

Eine Variante der Filteranordnung FA nach Fig. 5 ist in Fig. 6 dargestellt. Sie unterscheidet sich lediglich in den Teilfiltern TP1, TP3 und TP5, die hier jeweils als Weichen W1, W3 und W5 in Form einer Tiefpaß-Hochpaßkombination ausgebildet sind, und deren Hochpaßausgang jeweils mit einem Lastwiderstand R abgeschlossen ist. Auf diese Weise wird erreicht, daß über den gesamten Frequenzbereich der Senderarbeitsfrequenz fo hinweg im Sperrbereich der Teilfilter keine Oberwellen in die Senderendstufe zurückreflektiert, sondern in den Lastwiderständen R in Verlustwärme umgesetzt werden.

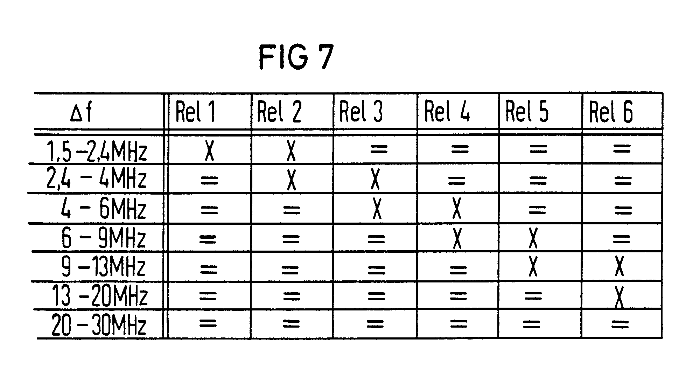

In der Tabelle der Fig. 7 sind in der ersten Spalte die sieben Teilfrequenzbereiche der Teilfilter angegeben. Die weiteren Spalten sind den Relais Rel1....Rel6 zugeordnet. Die beiden Umschaltkontakte der Relais Rel1....Rel6 sind in ihrer Stellung für ein Durchschalten des Signalwegs in der Tabelle der Fig. 7 durch zwei parallele waagrechte Linien dargestellt. Beide Schaltstrecken liegen hierbei zueinander parallel. Bei der Stellung der Umschaltkontakte im Sinne eines Anschaltens eines Teilfilters ist in der Tabelle dagegen ein Kreuz angegeben. Um die gewünschte Dämpfung in der Größenordnung von 40 dB bei der zweiten Oberwelle und höheren Oberwelle zu erhalten, sind, wie die Tabelle in Fig. 7 zeigt, beispielsweise für den Teilfrequenzbereich 1,5 bis 2,4 MHz die Teilfilter TP1 bzw. W1 und TP2 in den Signalweg eingeschaltet. In gleicher Weise sind für den Teilfrequenzbereich 2,4 bis 4 MHz die Teilfilter TP2 und TP3 bzw. W3 im Signalweg wirksam. Da die das Teilfilter für den höchsten Teilfrequenzbereich von 20 bis 30 MHz darstellende Außerbandweiche AW stets im Signalweg wirksam ist, ist für den Teilfrequenzbereich 13 bis 20 MHz nur noch das Teilfilter TP6 zusätzlich im Signalweg wirksam. Die Außerbandweiche AW muß natürlich, da sie ausschließlich für den Teilfrequenzbereich 20 bis 30 MHz zuständig ist, für eine Bemessung der Sperrdämpfung der zweiten Oberwellen von 40 dB entsprechend Fig. 3 ausgelegt sein.

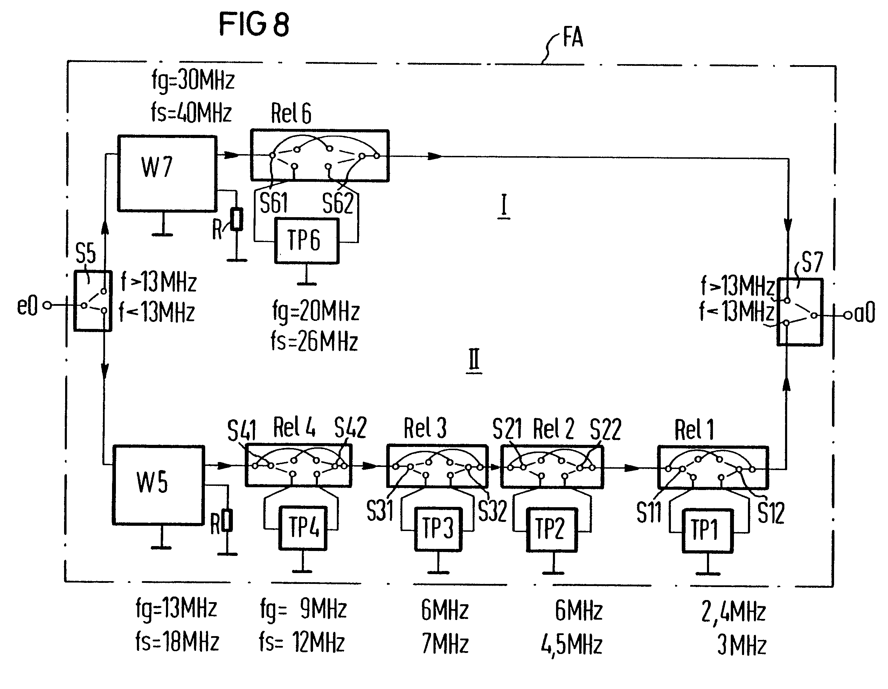

Die in Fig. 8 gezeigte Variante einer Filteranordnung FA stellt ein bevorzugtes Ausführungsbeispiel dar, bei dem von zwei Filterzweigen I und II Gebrauch gemacht wird. Die beiden Filterzweige können alternativ über den eingangsseitigen Schalter S5 und den ausgangsseitigen Schalter S7 zwischen den Eingang eO und den Ausgang aO geschaltet werden. Die beiden Schalter S5 und S7 werden jeweils durch ein Relais realisiert. Der Filterzweig I ist dabei für den Frequenzbereich fo > 13 MHz und der Filterzweig II für den Frequenzbereich fo < 13 MHz zuständig. Jeder der beiden Filterzweige weist gleichsam als festen Bestandteil eine Weiche W5 bzw. W7 aus einer Tiefpaß-Hochpaßkombination mit einem den Ausgang des Hochpasses abschließenden Lastwiderstand R auf. Der Weiche W7 im Filterzweig I kann für den Teilfrequenzbereich 13 bis 20 MHz das Teilfilter TP6 über das Relais Rel6 in Serie geschaltet werden. In gleicher Weise können der Weiche W5 im Filterzweig II wahlweise über die Relais Rel1....Rel4 die Teilfilter TP1....TP4 für sich oder gemeinsam mit einem weiteren Teilfilter in Serie geschaltet werden. Entsprechend den Fig. 5 und 6 sind auch in Fig. 8 die den einzelnen Teilfiltern bzw. Weichen zugehörigen Grenzfrequenzen fg und Sperrfrequenzen fs angegeben. Die Teilfilter TP1, TP2, TP3, TP4 und TP6 sind auch hier wiederum als Kauerparameter-Tiefpässe mit zwei Polen ausgeführt, während die Weichen W7 und W5, in ihrem Tiefpaßzweig dreipolig ausgeführt sind, da sie jeweils für sich die höhere Sperrdämpfung für die zweite Oberwelle erbringen müssen.

Bei der Filteranordnung FA nach Fig. 8 werden an den Teilfiltern reflektierte Oberwellen im Frequenzbereich oberhalb von 6 MHz in wünschenswerter Weise nicht in den Ausgang des Endverstärkers reflektiert. Hierzu werden im Unterschied zur Ausführungsform nach Fig. 6 lediglich zwei und nicht drei Teilfilter in Weichenausführung benötigt. Zwar ist bei der Ausführungsform nach Fig. 6 durch das als Weiche ausgeführte Teilfilter W1 gewährleistet, daß auch Oberwellen im Frequenzbereich unterhalb 6 MHz nicht in den Ausgang des Endverstärkers reflektiert werden. Bei vielen Anwendungsfällen ist jedoch diese Vorsichtsmaßnahme nicht erforderlich, da die Endverstärkerstufe in der Regel im unteren Frequenzbereich mehr Aussteuerreserve hat und deshalb in diesem Bereich in den Verstärkerausgang reflektierte Oberwellen die vom Sender auszustrahlenden Nutzdaten bei weitem nicht so beeinflussen können, wie das im mittleren und oberen Frequenzbereich der Fall wäre.

## Patentansprüche

1. In einem breiten Frequenzband durchstimmbarer Sender, insbesondere Kurzwellensender mit einem in Gegentakt arbeitenden Endverstärker, vorzugsweise Transistorverstärker, und einer zwischen dem Endverstärkerausgang und dem Senderausgang vorgesehenen Filteranordnung, deren Teilfilter (TP1....TPn), die bestimmten Teilfrequenzbereichen der Senderarbeitsfrequenz zugeordnet sind und der Unterdrückung unerwünschter Oberwellen der Senderarbeitsfrequenzen dienen, alternativ in Abhängigkeit der Senderarbeitsfrequenz ein- und ausgangsseitig über elektrisch steuerbare Schalter (S11, S12....) in den Signalweg einschaltbar sind,

dadurch gekennzeichnet, daß die Teilfilter (TP1....TPn) lediglich für eine ausreichend große Sperrdämpfung der Oberwellen n · fo der Senderarbeitsfrequenz fo bemessen sind, die geradzahlige Vielfache (n = 2,4....) hiervon sind, und daß die erforderliche Sperrdämpfung für Oberwellen n · fo, die ungeradzahlige Vielfache (n = 3,5,....) der Senderarbeitsfrequenz fo sind, durch zusätzliches Einschalten wenigstens eines weiteren Teilfilters in den Signalweg herbeigeführt ist, das hierbei, bezogen auf den durch die Senderarbeitsfrequenz fo bestimmten Teilfrequenzbereich, dem sich an diesen Teilfrequenzbereich in Richtung steigender Frequenzen anschließenden Teilfrequenzbereich zugeordnet ist.

2. Sender nach Anspruch 1,
dadurch gekennzeichnet, daß die Teilfilter (TP1....TPn) der Filteranordnung (FA) Tiefpaßcharakter aufweisende Suboktav-Filter sind.

3. Sender nach Anspruch 1 oder 2,
dadurch gekennzeichnet, daß das dem höchsten Teilfrequenzbereich der Senderarbeitsfrequenz fo zugeordnete Teilfilter zu einer Außerbandweiche (AW) in Form einer Tiefpaß-Hochpaßkombination erweitert ist, deren Hochpaßausgang ein Lastwiderstand (R) abschließt, und daß diese Außerbandweiche fest im Signalweg angeordnet ist.

4. Sender nach einem der vorhergehenden Ansprüche,

<u>dadurch gekennzeichnet</u>, daß, wenn den den x Teilfrequenzbereichen zugeordneten x Teilfiltern (TP1....TPv) der Filteranordnung (FA) eine Teilfilter -Ordnungszahl Z für Z = 1, 2, 3..... in Richtung zunehmender Frequenz der im Gesamtfrequenzbereich der Senderarbeitsfrequenz fo aufeinanderfolgenden Teilfrequenzbereiche zugeordnet wird, jene Teilfilter mit der Ordnungszahl Z = x - y für y eine ungerade ganze Zahl jeweils als Weiche (W2, W3, W5, AW) in Form einer Tiefpaß-Hochpaßkombination ausgeführt sind, deren Hochpaßausgang ein Lastwiderstand (R) abschließt.

5. Sender nach einem der Ansprüche 1 bis 3,

<u>dadurch gekennzeichnet</u>, daß die Filteranordnung (FA) zwischen Eingang (eO) und Ausgang (aO) zwei Filterzweige (I, II) aufweist, die wahlweise über elektrisch gesteuerte Schalter (S5, S7) alternativ zwischen Ein- und Ausgang wirksam sein können, daß ferner der eine Filterzweig (I) aus dem dem höchsten Teilfrequenzbereich für die Senderarbeitsfrequenz zugeordneten Teilfilter in Form einer Weiche (W7) und dem hierzu wahlweise in Reihe anschaltbaren, dem zweithöchsten Teilfrequenzbereich für die Senderarbeitsfrequenz zugeordneten Teilfilter (TP6) und der andere Filterzweig (II) aus dem dem dritthöchsten Teilfrequenzbereich für die Senderarbeitsfrequenz fo zugeordneten Teilfilter in Form einer Weiche (W5) und dem hierzu wahlweise in Reihe anschaltbaren, den übrigen Teilfrequenzbereichen der Senderarbeitsfrequenz fo zugeordneten Teilfiltern (TP1....TP4) bestehen, und daß bei den als Weiche ausgebildeten Teilfiltern (W5, W7) der nicht für die Anschaltung eines weiteren Teilfilters vorgesehene Ausgang mit einem Lastwiderstand (R) abgeschlossen ist.

6. Sender nach einem der vorhergehenden Ansprüche,

<u>dadurch gekennzeichnet</u>, daß die elektrisch steuerbaren Schalter Relais (Rel1...Rel6, S5, S7) sind, und daß hierbei jedem, in den Signalweg einschaltbaren Teilfilter ein Relais (Rel1....Rel6) mit zwei Umschaltkontakten und zwar einem filtereingangsseitigen (S11....S61) und einem filterausgangsseitigen Umschaltkontakt (S12...S62) zugeordnet ist.

## Claims

1. Transmitter, especially short-wave transmitter, which can be tuned in a wide frequency band and having a push-pull final amplifier, preferably transistor amplifier, and a filter arrangement provided between the final amplifier output and the transmitter output, the subfilters (TP1...TPn) of which filter arrangement, which are associated with certain component frequency ranges of the transmitter working frequency and serve to suppress undesired harmonics of the transmitter working frequencies, can be switched into the signal path alternatively on the input side and output side via electrically controllable switches (S11, 512...) depending on the transmitter working frequency, characterized in that the subfilters (TP1...TPn) are dimensioned solely for a sufficiently large stop band attenuation of the harmonics n · fo of the transmitter working frequency fo which are even multiples (n = 2,4...) hereof, and in that the required stop band attenuation for harmonics n · fo that are odd multiples (n = 3,5,...) of the transmitter working frequency fo is produced by additional switching into which, the signal path of at least one further subfilter, in this case, related to the component frequency range determined by the transmitter working frequency fo, is associated with the component frequency range adjoining this component frequency range in the direction of increasing frequencies.

2. Transmitter according to Claim 1, characterized in that the subfilters (TP1...TPn) of the filter arrangement (FA) are suboctave filters having the character of low-pass filters.

3. Transmitter according to Claim 1 or 2, characterized in that the subfilter associated with the highest component frequency range of the transmitter working frequency fo is expanded to an out-of-band separating filter (AW) in the form of a low-pass/high-pass combination, the high-pass output of which is terminated by a load resistance (R), and in that this out-of-band separating filter is arranged permanently in the signal path.

4. Transmitter according to one of the preceding claims, characterized in that, when the x subfilters (TP1...TPv) of the filter arrangement (FA) associated with the x component frequency ranges are associated with a subfilter ordinal number Z for Z = 1, 2, 3... in the direction of increasing frequency of successive component frequency ranges in the overall frequency range of the trans-mitter working frequency fo, those subfilters with the ordinal number Z = x - y where y is an odd whole number are designed in each case as a separating filter (W2, W3, W5, AW) in the form of a low-pass/high-pass combination, the high-pass output of which is terminated by a load resistance (R).

5. Transmitter according to one of Claims 1 to 3, characterized in that the filter arrangement (FA) has between input (eO) and output (aO) two filter branches (I, II) which may be optionally active alternatively between input and output by means of electrically controlled switches (S5, S7), in that furthermore one filter branch (I) is composed of the subfilter in the form of a separating filter (W7) associated with the highest component frequency range for the transmitter working frequency and the subfilter (TP6) associated with the second-highest component frequency range for the transmitter working frequency which can be optionally connected in series hereto, and the other filter branch (II) is composed of the subfilter in the form of a separating filter (W5) associated with the third-highest component frequency range for the transmitter working frequency fo and the subfilters (TP1...TP4) associated with the remaining component frequency ranges of the transmitter working frequency fo which can be optionally connected in series hereto, and in that, in the case of the subfilters (W5, W7) designed as a separating filter, the output which is not provided for the connection of a further subfilter is terminated by a load resistance (R).

6. Transmitter according to one of the preceding claims, characterized in that the electrically controllable switches are relays (Rel1....Rel6, S5, S7), and in that in this case each subfilter which can be switched into the signal path is associated with a relay (Rel1....Rel6) with two change-over contacts, specifically a switch-over contact on the filter input side (S11....S61) and one on the filter output side (S12....S62).

## Revendications

1. Emetteur dont la fréquence peut être variée dans une large bande de fréquence, en particulier émetteur à ondes courtes, comprenant un amplificateur final symétrique, de préférence un amplificateur à transistors, et un dispositif de filtrage prévu entre la sortie de l'amplificateur final et la sortie de l'émetteur, dont les filtres élémentaires (TP1....TPn), coordonnés à des gammes de fréquences partielles déterminées de la fréquence de fonctionnement de l'émetteur et servant à la suppression d'harmoniques indésirés des fréquences de fonctionnement de l'émetteur, sont interposables alternativement dans le chemin du signal, par leur entrée et leur sortie, au moyen d'interrupteurs (S11, S12....) à commande électrique, suivant la fréquence de fonctionnement de l'émetteur, caractérisé en ce que les filtres élémentaires (TP1....TPn) sont seulement conçus pour un affaiblissement de coupure suffisant des harmoniques n · fo de la fréquence de fonctionnement fo de l'émetteur constituant des multiples de nombres paires (n = 2,4....) de cette fréquence et que l'affaiblissement de blocage nécessaire pour les harmoniques n · fo constituant des multiples de nombres impaires (n = 3,5,....) de la fréquence de fonctionnement fo de l'émetteur, est produit par l'interposition additionnelle d'au moins un filtre élémentaire supplémentaire dans le chemin du signal, filtre élémentaire qui est coordonné à la gamme de fréquences partielle qui fait suite, dans le sens de l'augmentation des fréquences, à la gamme de fréquences partielle fixée par la fréquence de fonctionnement fo de l'émetteur.

2. Emetteur selon la revendication 1, caractérisé en ce que les filtres élémentaires (TP1....TPn) du dispositif de filtrage (FA) sont des filtres suboctaves ayant le caractère d'un filtre passe-bas.

3. Emetteur selon la revendication 1 ou 2, caractérisé en ce que le filtre élémentaire coordonné à la gamme de fréquences partielle la plus élevée de la fréquence de fonctionnement fo de l'émetteur, est complété pour constituer un filtre hors-bande (AW) sous la forme d'une combinaison d'un filtre passe-bas et d'un filtre passe-haut dont la sortie de la partie passe-haut est terminée par une résistance de charge (R), et que ce filtre hors-bande est disposée à demeure dans le chemin du signal.

4. Emetteur selon une des revendications précédentes, caractérisé en ce que, lorsqu'un nombre ordinal Z de filtre élémentaire, où Z = 1, 2, 3..., est coordonné dans le sens de l'augmentation de la fréquence des gammes de fréquences partielles qui se suivent dans l'ensemble de la gamme de la fréquence de fonctionnement fo de l'émetteur, aux x filtres élémentaires (TP1...TPv) coordonnés aux x gammes de fréquences partielles du dispositif de filtrage (FA), les filtres élémentaires ayant le nombre ordinal Z = x - y, où y est un nombre entier impair, sont réalisés chacun comme un filtre de bande (W2, W3, W5, AW) sous la forme de la combinaison d'un filtre passe-bas et d'un filtre passe-haut dont la sortie de la partie passe-haut est terminée par une résistance de charge (R).

5. Emetteur selon une des revendications 1 à 3, caractérisé en ce que le dispositif de filtrage (FA) présente, entre l'entrée (eO) et la sortie (aO), deux branches de filtrage (I, II) qui peuvent être rendues actives sélectivement et alternativement, entre l'entrée et la sortie, au moyen d'interrupteurs (S5, S7) à commande électrique, que, en outre, une branche de filtrage (I), constituée du filtre élémentaire coordonné à la gamme de fréquences partielle la plus haute pour la fréquence de fonctionnement de l'émetteur, sous la forme d'un filtre de bande (W7) et du filtre élémentaire (TP6) coordonné à la gamme de fréquences partielle la deuxième la plus haute pour la fréquence de fonctionnement de l'émetteur et pouvant être connecté sélectivement en série avec lui, et l'autre branche de filtrage (II) est constituée du filtre élémentaire, sous forme d'un filtre de bande (WS), coordonné à la gamme de fréquences partielle la troisième plus haute pour la fréquence de fonctionnement fo de l'émetteur, ainsi que de l'un au moins des filtres élémentaires (TP1....TP4) coordonnés aux autres gammes de fréquences partielles de la fréquence de fonctionnement fo de l'émetteur, filtre élémentaire qui peut être connecté en série avec lui, et que, parmi les filtres élémentaires réalisés comme des filtres de bande (W5, W7), la sortie non prévue pour la connexion d'un autre filtre élémentaire, est terminée par une résistance de charge (R).

6. Emetteur selon une des revendications précédentes, caractérisé en ce que les interrupteurs à commande électrique sont des relais (Rel1...Rel6, S5, S7) et qu'un relais (Rel1...Rel6) possédant deux contacts de commutation, un du côté de l'entrée du filtre (S11....S61) et un du côté de la sortie du filtre (S12....S62) est coordonné à chaque filtre élémentaire susceptible d'être interposé dans le chemin du signal.

# FIG 1

## FIG 2

## FIG 3

## FIG 4

EP 0 119 628 B1

**FIG 5**

Rel 1, Rel 2, Rel 3, Rel 4, Rel 5, Rel 6 — S11 S12, S21 S22, S31 S32, S41 S42, S51 S52, S61 S62 — TP1, TP2, TP3, TP4, TP5, TP6 — AW — R0 — FA

fg = 30MHz   2,4MHz   4MHz   6MHz   9MHz   13MHz   20MHz
fs = 4,0MHz   3MHz   4,5MHz   7MHz   12MHz   18MHz   16MHz

**FIG 6**

Rel 1, Rel 2, Rel 3, Rel 4, Rel 5, Rel 6 — S11 S12, S21 S22, S31 S32, S41 S42, S51 S52, S61 S62 — W1, TP2, W3, TP4, W5, TP6 — R — AW — R0 — FA

fg = 30   2,4MHz   4MHz   6MHz   9MHz   13MHz   20MHz
fs = 4,0MHz   3MHz   4,5MHz   7MHz   12MHz   18MHz   26MHz

5

## FIG 7

| Δf | Rel 1 | Rel 2 | Rel 3 | Rel 4 | Rel 5 | Rel 6 |
|---|---|---|---|---|---|---|
| 1,5 –2,4MHz | X | X | = | = | = | = |
| 2,4 – 4MHz | = | X | X | = | = | = |
| 4 – 6MHz | = | = | X | X | = | = |
| 6 – 9MHz | = | = | = | X | X | = |
| 9 –13MHz | = | = | = | = | X | X |
| 13 –20MHz | = | = | = | = | = | X |
| 20 –30MHz | = | = | = | = | = | = |

FIG 8